# EUROPEAN PATENT APPLICATION

(11) **EP 2 645 837 A1**
(43) Date of publication of application: **02.10.2013**
(21) Application number: 12305368.8
(22) Date of filing: 29.03.2012
(51) Int. Cl.: H05K 7/20, F16B 1/00, F03G 7/06

(54) **Device for thermoelectric heat exchange**

(71) Applicant: Alcatel Lucent, 75007 Paris (FR)
(72) Inventor: Donnelly, Brian, Dublin 15 (IE); Jeffers, Nick, Dublin 15 (IE)
(74) Representative: Shamsaei Far, Hassan

(57) **Abstract**

A shape memory device, comprising a base mount, a moveable body and a shape memory alloy element attached to the base mount and the moveable body. In response to an activation command, the shape memory alloy element changes state, from a flexible state in which the moveable body is located at a first distance from the base mount, to a rigid state in which the moveable body is located at a second distance from the base mount. A thermoelectric heat exchanger is using the shape memory device is also disclosed.

## Description

### BACKGROUND ART

Microprocessors on computing boards within server blade chassis typically generate a large amount of heat. In order to remove this heat, use is typically made of copper heat sinks mounted directly onto the microprocessor. These heat sinks are typically large thus giving rise to an increase of the surface area which in turn reduces the heat flux that would allow the heat to be dissipated to air forced over the heat sink.

### SUMMARY

The heat sinks are typically large, heavy, expensive and at the limit of their performance. In occasions fans are used to cool the boards; however, fans typically run at high powers and, as is often the case, overcool other boards within the chassis. This results in an inefficient usage of electrical power. Furthermore, fans generate noise and the noise needs to be maintained under certain limits established by industry standards such as Network Equipment-Building System (NEBS). Limiting the level of noise limits the cooling capacity of the fans which in practice may become problematic.

Furthermore, it is expected that chip power densities increase with time as new designs are made, thus making the solutions using large heat sinks less practical and less attractive.

As mentioned above, a considerable amount of space on the board is typically taken up by the heat sinks, thus presenting challenges for board designers. Furthermore, it is important to give due consideration to the position of other components on the board (e.g. power amplifiers/capacitors) so as not to inhibit air flow into the heat sinks.

Additionally, the next generation boards aim to double the computing power (and thus causing increase in the heat generated) which also makes the search for a new solution still more desirable.

It is therefore desired to devise a different way to remove the heat from heat sources such as microprocessors, avoiding as much as possible, the use of large on-board heat sinks. The solution proposed herein is directed to an attempt to overcome at least some of the drawbacks associated with the use of the typically costly, heavy and expensive known heat sinks and to provide a comparatively less expensive and more reliable solution for removing, possibly even higher amounts of, heat.

Embodiments of the disclosure feature a shape memory device, comprising a base mount, a moveable body and a shape memory alloy element attached to the base mount and the moveable body, the shape memory alloy element being configured to change state, in response to an activation command, from a flexible state in which the moveable body is located at a first distance from the base mount, to a rigid state in which the moveable body is located at a second distance from the base mount.

According to some specific embodiments, the shape memory alloy element is interposed between the base mount and the moveable body.

According to some specific embodiments, the second distance is longer than the first distance.

Some embodiments of the disclosure relate to a thermoelectric heat exchanger for dissipating heat from a device, the thermoelectric heat exchanger comprising the shape memory device as featured herein.

According to some specific embodiments, the thermoelectric heat exchanger further comprises a heat dissipater and a first heat pipe, wherein in the rigid state the shape memory device is configured to apply pressure by means of the moveable body to the first heat pipe causing the heat pipe to transfer heat to the heat dissipater.

According to some specific embodiments the first heat pipe is thermally connected to a heat source comprised in a board wherein the heat pipe has an end extending from an edge of the board said end configured for providing thermal contact with the heat dissipater.

According to some specific embodiments the heat dissipater further comprises a second heat pipe thermally connected to a thermoelectric cooler.

According to some specific embodiments the second heat pipe and the thermoelectric cooler are configured to transfer heat from the first heat pipe to a heat sink comprised in the heat dissipater.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figures 1 a, 1 b and 1 c are exemplary schematic representations of a shape memory device in exploded view, assembled but deactivated view and assembled and activated view respectively according to some embodiments.
Figure 2a and 2b are exemplary schematic representations of a heat dissipater in exploded and assembled configurations respectively.
Figures 3a and 3b are exemplary schematic representations of a board comprising electronic circuitry and a heat dissipater in disengaged and engaged configurations respectively.
Figure 4 is an exemplary schematic representation of the thermoelectric heat exchanger according to some embodiments.

### DETAILED DESCRIPTION

The proposed solution makes use of the properties of the so-called shape memory alloys in order to construct a shape memory device as proposed herein.

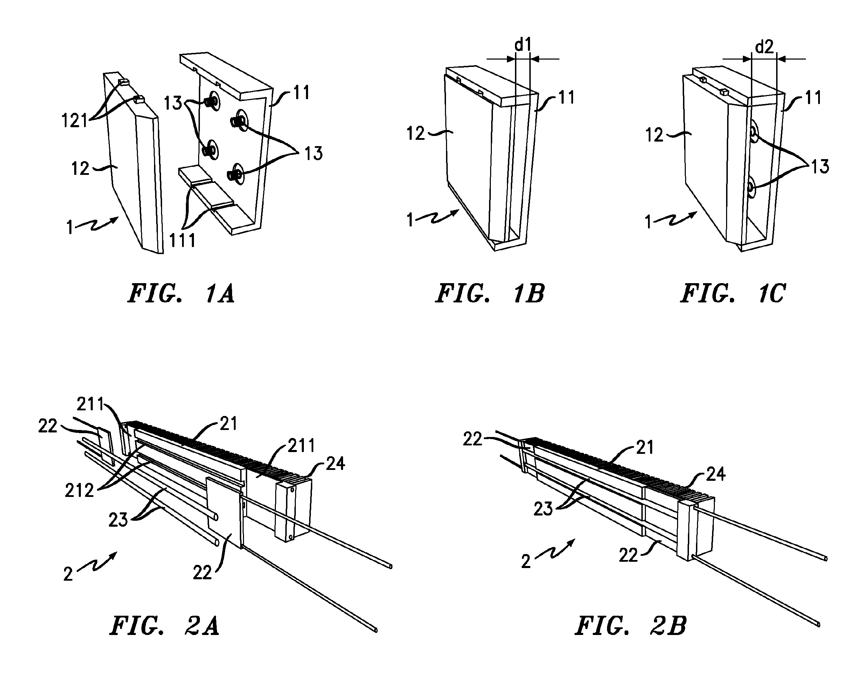

Figures 1a, 1b and 1c show exemplary schematic representations of a shape memory device 1 in exploded view, assembled but deactivated view and assembled and activated view respectively.

As is more clearly shown in figure 1 a, the shape memory device 1 comprises a base mount 11, a moveable body 12 and one or more shape memory alloy element(s) 13. In figure 1 a, four shape memory alloy elements 13 are shown, however any convenient number of shape memory alloy elements may be used. The base mount 11 may be made of any convenient material. Preferably the base mount 11 is designed such that it may be mounted, in stationary state, on a fixed part of an equipment such as for example a chassis. The base mount 11 may have a structure suitable to receive the moveable body 12 and allow movement of the moveable body 12 within its structure. For example, as shown in figures 1 a-1 c, the base mount 11 may have a plurality of guiding slots 111, configured and shaped to receive respective projections such as knobs 121 located on the moveable body 12.

The moveable body 12 may have any convenient shape and/or structure as long as such shape and/or structure are suitable for performing the functionalities as described herein.

The shape memory alloy element 13 is made of a material that is capable of assuming a predefined shape upon reaching a certain temperature. Examples of such material are copper-aluminium-nickel and nickel-titanium while other alloys may also be made by alloying zinc, copper, gold and iron, according to the requirements of each specific application. In figures 1a and 1 c, the shape memory alloy element 13 is shown to have the shape of a spring (not visible in figure 1b), however the shape memory alloy element 13 may have any convenient shape or structure.

The shape memory alloy element 13 may be attached to the base mount 11 (as shown in figure 1 a) at one end, and to the moveable body 12 at another end. Therefore, as assembled, the shape memory alloy element 13 is interposed between the base mount 11 and the moveable body 12 and maintains the two latter bodies at a distance from each other (figures 1 b and 1 c).

In the example shown in figure 1 b, the shape memory device 1 is shown in assembled configuration. It is assumed that, in this configuration, each of the shape memory alloy elements 13 is in a deactivated or idle state. This means that no activation command is applied to the shape memory alloy elements 13 and therefore each shape memory alloy element 13 is in a first (deactivated) shape. For example, where the shape memory alloy element is a spring, in the deactivated configuration of figure 1 b, the spring is in its idle (non-compressed, and non-stretched) and flexible state. In this idle state (in rest position), springs 13 maintain the moveable body 12 at a first distance d1 from the base mount 11. By activating the shape memory alloy elements 13, using an activation command, the shape memory alloy elements 13 change shape. As a result of the shape change, the shape memory alloy elements 13 exert a force on the moveable body 12 causing it to move a certain distance relative to the base mount 11. Upon activation, the shape memory alloy elements 13 remain rigid and thus maintains the moveable body 12 in its new position.

Figure 1 c shows the shape memory device 1 in activated configuration. In this figure it may be observed that the moveable body 12 is held at a second distance d2 from the base mount 11. Comparison between figures 1 b and 1 c shows that the second distance d2 is larger than the first distance d1.

This property of the shape memory device 1 may therefore be used in order to exert pressure upon a body by activation of the shape memory alloy elements 13. As the activation of the shape memory alloy elements 13 may be performed at any desired time, the device may be selectively activated based on the requirements or circumstances of each application. Therefore, heat may be made to dissipate when required.

Referring now to figure 2a and 2b, exemplary schematic representations of a heat dissipater are shown in exploded and assembled configurations respectively. The exemplary heat dissipater 2 comprises a support structure 21, one or more thermoelectric coolers 22 (TEC) and one or more heat pipes 23. Preferably the heat dissipater 2 may also comprise a heat sink structure 24.

As shown in the exploded configuration of figure 2a, the support structure 21 may comprise first recessed portions 211 with a shape in conformity with the shape of the TECs 22 in order to receive them, and engage in thermal contact with them, when the heat dissipater is assembled as shown in figure 2b. TECs are known solid state devices that act as heat pumps when an electric current is passed through them.

Furthermore, the support structure 21 may comprise second recessed portions 212 with a shape in conformity with the shape of the heat pipes 23 in order to receive them when the heat dissipater is assembled as shown in figure 2b. Heat pipes are known solid state devices that efficiently transport heat from one position to another.

In the assembled configuration (figure 2b) the heat pipes 23 may receive heat from an external body by means of thermal contact and transfer the received heat to the TECs 22. The TECs may in turn transfer the received heat to the support structure 21. In particular, when an electric current is applied to the TECs 22, the TECs are capable of transferring heat at a higher pace as compared to when the electric current is absent.

The support structure 21 may be made of a material with efficient heat transfer properties such as metals.

The support structure 21 may in turn transfer the received heat to the heat sink 24 from where the received heat is dissipated as is known.

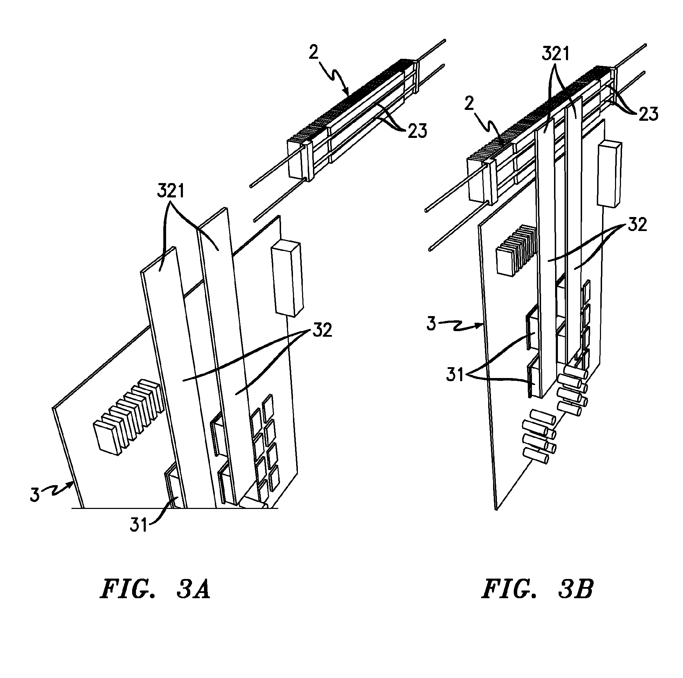

Referring now to figures 3a and 3b, exemplary schematic representations of a board 3 and a heat exchanger 2 are shown in disengaged and engaged configurations respectively.

The board 3 comprises electronic circuitry including devices which generate heat, herein also referred to as heat sources, such as for example microprocessors 31 (for simplification, other electronic components shown on the board are not referenced as they are not relevant for the understanding of the present description).

Heat pipes 32 are attached to the board such that they are in thermal contact with the heat sources 31. In the figures, heat pipes 32 are shown to be flat so as to allow a more effective thermal contact with the bodies to or from which they transport heat. However, other shapes may likewise be used.

The board 3 may be manufactured with the heat pipes 32 mounted directly onto the heat sources 31 protruding some distance from the top of the board as shown in the figures by reference numeral 321. The heat pipes 32 may be positioned at an offset distance from the board surface by means of thermal spreaders (not shown) that may allow the desired clearance for other board components.

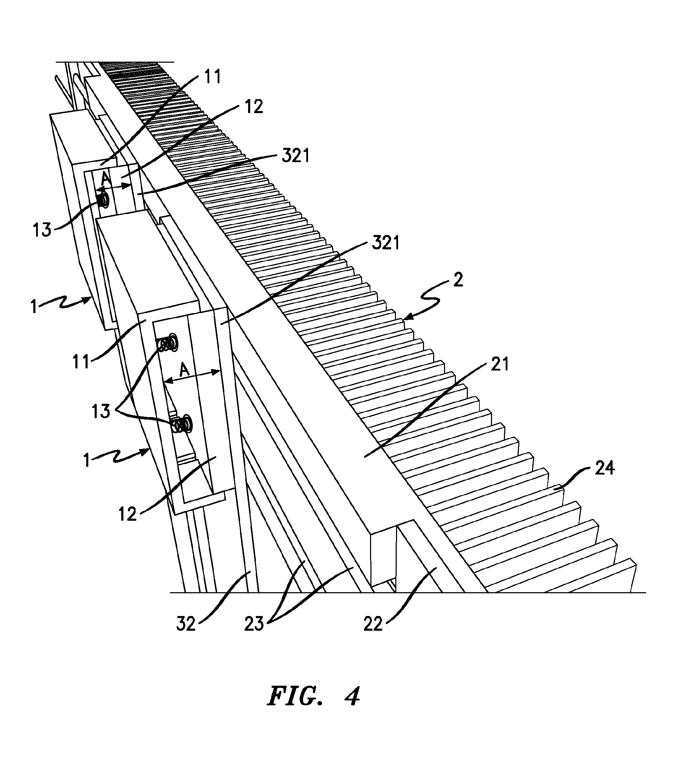

The board 3 may then be slid into place within the chassis of the equipment (not shown) where the exposed end 321 of the heat pipes 32 can enter into contact with the heat dissipater 2 mounted on the chassis of the equipment. Figure 3b shows this situation with the board 3 and the heat dissipater 2 in engaged position. As shown in this figure heat pipes 32 may be made to enter into in thermal contact with heat pipes 23 of the heat dissipater 2. This is described in further detail with reference to figure 4.

As shown in figure 4, in the engaged position described above, the exposed ends 321 of the heat pipes 32 may be brought into contact with the heat pipes 23 of the heat dissipater 2 by activating the shape memory device 1. For a better understanding of the following description, the heat pipes 32 of the board 3 will hereinafter be referred to as first heat pipes, and the heat pipes 23 of the heat dissipater will hereinafter be referred to as second heat pipes.

In figure 4, the board 3 itself is not shown for simplicity, however it may be assumed that the position of the board relative to the heat dissipater 2 is similar to that described in relation to figure 3b. The heat dissipater 2 may be observed with the support structure 21, the TECs 22, the heat pipes 23 and the heat sink 24. Furthermore, it may be observed that the exposed ends 321 of the first heat pipes 32 are brought into thermal contact with the second heat pipes 23 of the dissipater 2. This is achieved by means of activating the shape memory device 1 which corresponds to the position shown in figure 4.

Each base mount 11 may be fixed onto a stationary structure, for example the chassis of the equipment (not shown). The moveable body 12 may therefore move toward and away from the first heat pipe 32 as shown by means of arrow A. In the deactivated state the shape memory alloy elements, in this case springs, 13 are in idle state, as described in relation to figure 1 b, thereby maintaining the moveable body 12 closer to the base mount 11 (at distance d1 in figure 1 b). Accordingly the moveable body 12 does not apply pressure to the first heat pipe 32 in order to bring it into thermal contact with second heat pipes 23. Once the springs 13 are activated, they change shape and extend outward, as described in relation to figure 1 c. By this action, the moveable body 12 is caused to move away from the base mount 11 (to distance d2 in figure 1 c). As a consequence of this outward move, the moveable body 12 applies pressure on the first heat pipe 32 at the exposed end 321 thereof. The springs 13, being in their rigid state, maintain the moveable body 12 in this outward position as the moveable body 12 applies pressure on the first heat pipe 32.

The first heat pipe 32 in turn applies pressure on the second heat pipes 23 thereby reducing thermal resistance at the contact interface between the first and the second heat pipes 32 and 23.

In this position, therefore, heat generated by heat sources 31 (figures 3a and 3b) may be first absorbed by the first heat pipes 32 and transferred to the second heat pipes 23. The heat is subsequently transferred from the second heat pipes 23 to the TECs 22, from the TECs 21 to the support structure 21 and from the latter to the heat sink structure 24 where it is eventually dissipated in the surrounding air.

Advantageously the second heat pipes 23 may additionally transfer heat received from the first heat pipes 32 directly to the support structure 21 through the second recessed portions 212 in the support structure where the second heat pipes are located.

If faster or more efficient heat transfer is required the TECs 22 may be activated by an electric current. Otherwise, the TEC may remain in deactivated state in which heat transfer is still possible although at a lower pace as compared to their activated state. This latter option however has the advantage of not requiring power to activate the TECs, thereby reducing energy consumption and avoiding the heat generated as a result of powering requirements of the TECs.

When power is supplied to the TEC, one side increases in temperature while the other decreases, this acts as a heat pump transporting heat from the cold to hot side. In the figure, the side facing towards the viewer is the cold side. The hot side is mounted to the heat dissipater support structure through which the heat is dissipated to the air flow. The cold side provides cooling for the microprocessor via the second heat pipes 23.

The shape memory alloy is activated when a certain temperature is reached. This temperature may be chosen, within practical ranges, by the designer. As a result of such activation the moveable body is caused to apply pressure to reduce the thermal resistance of the interface between the first and the second heat pipes as described above.

The proposed solution improves on the current designs by freeing up large amounts of space on the board, for example by removing the on-board heat sinks (the heat sink used in the heat dissipater is away from the board and does not occupy board surface). This gives the board designers more freedom as they would not need to consider the positioning of components relative to the on-board heat sink. Furthermore, the proposed solution may be implemented by using inexpensive technology with a proven track record such as heat pipes and TECs.

Air flow (powered by fans) may be employed to pass over the board, cooling the low power components. It may then pass through the chassis based heat dissipater, removing the heat generated by the heat sources (e.g. microprocessors).

As mentioned above, the TECs may be used to provide extra cooling only when required. It is known that the current designs typically require cooling fans to run at maximum allowable power in order to cool the heat sources, typically two microprocessors, on the compute board within the chassis. However, not all boards are compute boards. Switching boards dissipate relatively low amounts of heat. This means that the current solutions may overcool many components on the compute boards and overcool the entire other boards (such as switching boards). This results in a very inefficient cooling solution.

The solution proposed herein allows the TECs to be powered up only when required. For the majority of the time, when the boards are running at average power levels, the TEC may be powered down, thus relying on the heat dissipater alone to remove the heat generated. This may greatly increase the efficiency of the overall system. It may also allow higher power boards to be used in the chassis as the heat is removed more effectively.

The solution proposed herein presents even further advantages as compared to the current solutions. One of such further advantages may be the control of the ambient air temperature which in occasions is a limiting factor to heat transfer, when use is made of the current solutions. According to the NEBS standards, the limit for high ambient air temperature that the heat is to be dissipated to is 55 °C. This, in practice, may present a significant design problem.

The use of TECs as proposed herein may overcome this limit at least to some extent. As already mentioned above, when power is supplied to the TEC, one side reduces significantly in temperature below ambient. The other side increases in temperature. Heat is then 'pumped ' from the cold to hot side. A heat sink, attached to the hot side of the TEC may then be used to dissipate heat to the surrounding air. The increased temperature gradient at the hot side of the TEC results in a higher maximum heat dissipation (i.e. the higher temperature difference drives better heat transfer to the 55 °C ambient). The cold side acts as a heat sink for power dissipated by the heat source, e.g. CPU (through the heat pipe). However, the use of the TEC would require the supply of power which in turn may cause some increase in ambient temperature.

As mentioned above, the generation of this heat may be controlled in the proposed solution. The control is made possible because TECs will only be required when heat source power levels exceed a certain value. Thus it may be assumed that, at least in some applications, for the majority of the time the TECs will operate at very low power or no power at all. This results in an active cooling solution that will increase efficiency.

This invention may advantageously allow higher power components to be used on boards within server blade chassis. This allows more functionality for the same spatial footprint, i.e. by increasing (or even doubling) the computing power of the server boards, the end user would require less equipment, or, for the same spatial footprint, the end user could have an increased computing power and/or functionality. In addition, due to the configuration of the proposed setup, the efficiency of the overall system would increase, reducing running cost.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the invention.

It should be appreciated by those skilled in the art that any block diagrams herein represent conceptual views of illustrative circuitry embodying the principles of the invention.

## Claims

1. A shape memory device, comprising a base mount, a moveable body and a shape memory alloy element attached to the base mount and the moveable body, the shape memory alloy element being configured to change state, in response to an activation command, from a flexible state in which the moveable body is located at a first distance from the base mount, to a rigid state in which the moveable body is located at a second distance from the base mount.

2. The device of claim 1, wherein the shape memory alloy element is interposed between the base mount and the moveable body.

3. The device of claim 1 or claim 2, wherein the second distance is longer than the first distance.

4. A thermoelectric heat exchanger for dissipating heat from a device, the thermoelectric heat exchanger comprising the shape memory device of any one of claims 1 to 3.

5. The thermoelectric heat exchanger of claim 4 further comprises a heat dissipater and a first heat pipe, wherein in the rigid state the shape memory device is configured to apply pressure by means of the moveable body to the first heat pipe causing the heat pipe to transfer heat to the heat dissipater.

6. The thermoelectric heat exchanger of claim 5, wherein the first heat pipe is thermally connected to a heat source comprised in a board wherein the heat pipe has an end extending from an edge of the board said end configured for providing thermal contact with the heat dissipater.

7. The thermoelectric heat exchanger of any one of claims and claim 6, wherein the heat dissipater further comprises a second heat pipe thermally connected to a thermoelectric cooler.

8. The thermoelectric heat exchanger of claim 7, wherein the second heat pipe and the thermoelectric cooler are configured to transfer heat from the first heat pipe to a heat sink comprised in the heat dissipater.
